# EUROPEAN PATENT APPLICATION

(11) **EP 4 757 503 A1**
(43) Date of publication of application: **10.06.2026**
(21) Application number: 25217488.3
(22) Date of filing: 20.11.2025
(51) Int. Cl.: H05K 1/02, H05K 1/11, H05K 1/185, H05K 3/28, H05K 3/46

(54) **METHOD FOR MANUFACTURING CHIP-EMBEDDED CIRCUIT BOARD AND CHIP-EMBEDDED CIRCUIT BOARD**

(30) Priority: 05.12.2024 CN 202411785910
(71) Applicant: ZF Friedrichshafen AG, 88046 Friedrichshafen (DE)
(72) Inventor: YUAN, George, Shanghai 201615 (CN); XU, Qing, Shanghai 201615 (CN)
(74) Representative: Nowack, Linda

(57) **Abstract**

The present disclosure relates to the technical field of circuit boards, and provides a method for manufacturing a chip-embedded circuit board, and a chip-embedded circuit board. The method for manufacturing a chip-embedded circuit board includes: providing a mounting recess in a pre-manufactured circuit board; embedding a chip packaging unit in the mounting recess such that upper and lower surfaces of the chip packaging unit are flush with upper and lower surfaces of the pre-manufactured circuit board, respectively; and forming an electrode lead-out structure on the upper surface of the pre-manufactured circuit board by: stacking a dielectric layer and a conductive layer on the upper surface of the pre-manufactured circuit board, providing through holes in the dielectric layer and the conductive layer to expose electrodes of the chip packaging unit, and filling the through holes with a conductive material to form electrode leads of the chip packaging unit; and providing slots in a back surface of the chip packaging unit to form heat dissipation fins in such a way that the heat dissipation fins are flush with the lower surface of the pre-manufactured circuit board. The manufacturing method of the present disclosure can manufacture a chip-embedded circuit board with a robust structure that meets the operational performance and the heat dissipation performance.

## Description

### Technical Field

The present disclosure relates to the technical field of circuit boards, and particularly, to a method for manufacturing a chip-embedded circuit board, and a chip-embedded circuit board.

### Background Art

In automotive parts such as inverters, chip-embedded circuit boards can be used to improve integration. The chip-embedded circuit board is a complex structure. How to manufacture the chip-embedded circuit board to enable the chip-embedded circuit board to meet operational performance and heat dissipation performance and to ensure the robustness of the structure is a problem that needs to be addressed.

It should be noted that information disclosed in the above background art section is only used to enhance the understanding of the background of the present disclosure, and therefore may include information that does not form the prior art known to those of ordinary skill in the art.

### Summary

In view of this, the present disclosure provides a method for manufacturing a chip-embedded circuit board, and a chip-embedded circuit board, to form a chip-embedded circuit board with a robust structure that meets the operational performance and the heat dissipation performance.

According to an aspect of the present disclosure, a method for manufacturing a chip-embedded circuit board is provided, including: providing a mounting recess in a pre-manufactured circuit board; embedding a chip packaging unit in the mounting recess such that upper and lower surfaces of the chip packaging unit are flush with upper and lower surfaces of the pre-manufactured circuit board, respectively; and forming an electrode lead-out structure on the upper surface of the pre-manufactured circuit board by: stacking a dielectric layer and a conductive layer on the upper surface of the pre-manufactured circuit board, providing through holes in the dielectric layer and the conductive layer to expose electrodes of the chip packaging unit, and filling the through holes with a conductive material to form electrode leads of the chip packaging unit; and providing slots in a back surface of the chip packaging unit to form heat dissipation fins in such a way that the heat dissipation fins are flush with the lower surface of the pre-manufactured circuit board.

In some embodiments, stacking a dielectric layer and a conductive layer on the upper surface of the pre-manufactured circuit board includes: stacking the dielectric layer of a resin material on the upper surface of the pre-manufactured circuit board; and stacking and laminating the conductive layer on an upper surface of the dielectric layer, such that the conductive layer is fixedly connected to the pre-manufactured circuit board by the dielectric layer.

In some embodiments, providing through holes in the dielectric layer and the conductive layer to expose electrodes of the chip packaging unit includes: etching the conductive layer to form an electrode pattern; and performing laser drilling on the electrode pattern to form the through holes that extend through the conductive layer and the dielectric layer and from which the electrodes of the chip packaging unit are exposed.

In some embodiments, filling the through holes with a conductive material to form electrode leads of the chip packaging unit includes: filling the through holes with a copper material by electroplating, to form the electrode leads.

In some embodiments, the step of forming an electrode lead-out structure on the upper surface of the pre-manufactured circuit board is repeated a plurality of times.

In some embodiments, a dielectric layer is stacked for a second time such that the dielectric layer stacked for the second time covers the electrode leads formed for a first time and areas not covered by the electrode leads formed for the first time, and an upper surface of the dielectric layer stacked for the second time is flat; and electrode leads are formed for the second time such that the electrode leads formed for the second time are connected to the electrode leads formed for the first time.

In some embodiments, during forming the electrode lead-out structure on the upper surface of the pre-manufactured circuit board, the lower surface of the pre-manufactured circuit board is further etched to form a conductive pattern.

In some embodiments, the manufacturing method further includes: forming an insulating protective layer in areas that are above the pre-manufactured circuit board and that are not covered by the electrode leads, and/or in areas that are below the pre-manufactured circuit board and that are not covered by the conductive pattern.

According to another aspect of the present disclosure, a chip-embedded circuit board is provided and manufactured by using the manufacturing method according to any one of the above embodiments, where the chip-embedded circuit board includes: a pre-manufactured circuit board; a chip packaging unit embedded in a mounting recess in the pre-manufactured circuit board, wherein upper and lower surfaces of the chip packaging unit are flush with upper and lower surfaces of the pre-manufactured circuit board, respectively; and an electrode lead-out structure formed on the upper surface of the pre-manufactured circuit board and including: a dielectric layer and a conductive layer that are stacked on the upper surface of the pre-manufactured circuit board, through holes extending through the dielectric layer and the conductive layer to connect electrodes of the chip packaging unit, and a conductive material filled in the through holes to form electrode leads of the chip packaging unit; and heat dissipation fins provided on a back surface of the chip packaging unit, wherein the heat dissipation fins are flush with the lower surface of the pre-manufactured circuit board.

In some embodiments, the chip-embedded circuit board further includes: an insulating protective layer disposed above the pre-manufactured circuit board and covering areas not covered by the electrode leads, where when a conductive pattern is formed on the lower surface of the pre-manufactured circuit board, the insulating protective layer is also disposed below the pre-manufactured circuit board, and covers areas not covered by the conductive pattern.

Compared with the prior art, the present disclosure has at least the following beneficial effects.

In the present disclosure, the chip packaging unit is embedded in the mounting recess of the pre-manufactured circuit board, and the upper and lower surfaces of the chip packaging unit are flush with the upper and lower surfaces of the pre-manufactured circuit board, respectively, to form a stable preliminary structure of the chip-embedded circuit board. Further, in the present disclosure, the electrode lead-out structure is formed on the upper surface of the pre-manufactured circuit board for leading out the electrodes of the chip packaging unit, so as to be connected to other cooperative electronic elements to implement the operational performance of the chip-embedded circuit board. In the present disclosure, the slots are further provided on the back surface of the chip packaging unit to form the heat dissipation fins for increasing a heat dissipation area of the chip packaging unit, thereby implementing effective heat dissipation of the chip packaging unit and the pre-manufactured circuit board, and improving heat dissipation performance of the chip-embedded circuit board. In addition, the heat dissipation fins are flush with the lower surface of the pre-manufactured circuit board, so that the overall structure of the chip-embedded circuit board is stable.

Thereby, with the method for manufacturing a chip-embedded circuit board in the present disclosure, the chip-embedded circuit board with the robust structure that meets the operational performance and the heat dissipation performance can be manufactured.

It should be understood that the above general description and the following detailed description are only exemplary and explanatory, and cannot limit the present disclosure.

### Brief Description of the Drawings

The accompanying drawings herein, which are incorporated into and constitute a part of the description, illustrate embodiments consistent with the present disclosure and, together with the description, are used to explain principles of the present disclosure. Obviously, the accompanying drawings described below show merely some of the embodiments of the present disclosure, and those of ordinary skill in the art would also have obtained other accompanying drawings according to these accompanying drawings without any creative effort.
FIG. 1 is a schematic diagram of steps of a method for manufacturing a chip-embedded circuit board according to an embodiment of the present disclosure;
FIG. 2 is a schematic structural diagram of a chip-embedded circuit board according to an embodiment of the present disclosure;
FIG. 3 is a schematic structural diagram of an electrode pattern formed in a conductive layer during manufacturing of a chip-embedded circuit board according to an embodiment of the present disclosure;
FIG. 4 is a schematic structural diagram of through holes formed in a conductive layer and a dielectric layer during manufacturing of a chip-embedded circuit board according to an embodiment of the present disclosure;
FIG. 5 is a schematic structural diagram of electrode leads formed during manufacturing of a chip-embedded circuit board according to an embodiment of the present disclosure;
FIG. 6 is a schematic structural diagram of a second dielectric layer formed during manufacturing of a chip-embedded circuit board according to an embodiment of the present disclosure;
FIG. 7 is a schematic structural diagram of a second electrode pattern formed during manufacturing of a chip-embedded circuit board according to an embodiment of the present disclosure;
FIG. 8 is a schematic structural diagram of a second layer of through holes formed during manufacturing of a chip-embedded circuit board according to an embodiment of the present disclosure;
FIG. 9 is a schematic structural diagram of a second layer of electrode leads formed during manufacturing of a chip-embedded circuit board according to an embodiment of the present disclosure;
FIG. 10 is a schematic structural diagram of heat dissipation fins formed during manufacturing of a chip-embedded circuit board according to an embodiment of the present disclosure;
FIG. 11 is a schematic structural diagram of a chip packaging unit embedded in a pre-manufactured circuit board during manufacturing of a chip-embedded circuit board according to an embodiment of the present disclosure; and
FIG. 12 is a schematic structural diagram of an insulating protective layer formed during manufacturing of a chip-embedded circuit board according to an embodiment of the present disclosure.

### Detailed Description of Embodiments

Now, exemplary implementations will be described more fully with reference to the accompanying drawings. However, the exemplary implementations can be implemented in many forms and should not be construed as being limited to the implementations described herein. On the contrary, these implementations are provided to make the present disclosure more thorough and complete, and to fully convey the concept of the exemplary implementations to those skilled in the art.

The accompanying drawings are only schematic illustrations of the present disclosure, and are not necessarily drawn to scale. In the accompanying drawings, the same reference numerals denote the same or similar parts, and thus the repeated description thereof will be omitted.

The processes shown in the accompanying drawings are only exemplary illustrations, and do not necessarily include all steps. For example, some steps can be divided, and some steps can be combined or partially combined, and the actual execution order thereof may be changed based on actual conditions.

The terms "first", "second" and similar terms used in the specific description do not denote any order, quantity, or importance, but are merely used to distinguish between different components. Orientations or positional relationships indicated by the terms such as "upper" and "lower" are based on orientations or positional relationships shown in the drawings, which is only for convenience of describing the present disclosure and simplifying the description, rather than indicating or implying that an apparatus or an element referred to must have a specific orientation or be constructed and operated in a specific orientation, and therefore cannot be construed as limiting the present disclosure. The term "a plurality of" means two or more, unless otherwise explicitly and specifically defined. Moreover, in the description of the present disclosure, when it is said that a device is "connected" to another device, this includes not only the case of direct connection but also the case of indirect connection through other elements.

It should be noted that the embodiments in the present disclosure and features of the various embodiments can be combined with each other without conflict.

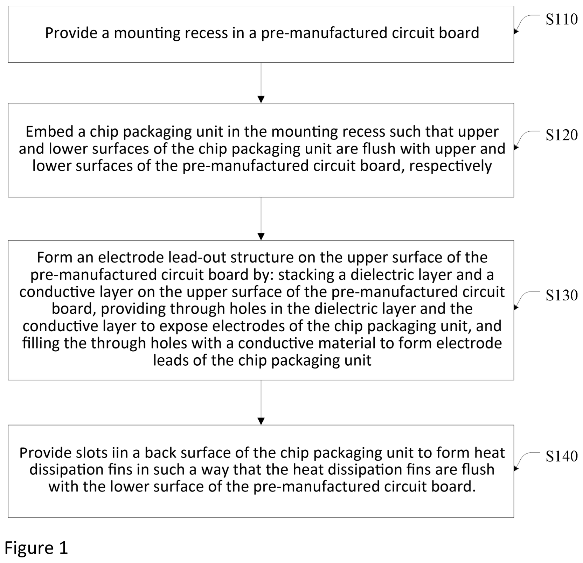

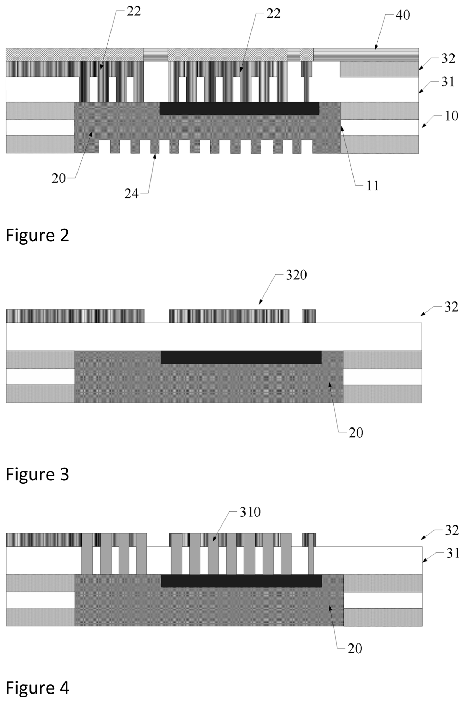

FIG. 1 shows main steps of a method for manufacturing a chip-embedded circuit board. FIG. 2 shows a structure of a chip-embedded circuit board. As shown in FIG. 1 and FIG. 2, the method for manufacturing a chip-embedded circuit board according to an embodiment of the present disclosure includes the following steps.

At step S110, a mounting recess 11 is provided in a pre-manufactured circuit board 10.

At step S120, a chip packaging unit 20 is embedded in the mounting recess 11 such that upper and lower surfaces of the chip packaging unit 20 are flush with upper and lower surfaces of the pre-manufactured circuit board 10, respectively.

At step S130, an electrode lead-out structure is formed on the upper surface of the pre-manufactured circuit board 10 by: stacking a dielectric layer 31 and a conductive layer 32 on the upper surface of the pre-manufactured circuit board 10, providing through holes in the dielectric layer 31 and the conductive layer 32 to expose electrodes of the chip packaging unit 20, and filling the through holes with a conductive material to form electrode leads 22 of the chip packaging unit 20.

At step S140, slots are provided in a back surface of the chip packaging unit 20 to form heat dissipation fins 24 in such a way that the heat dissipation fins 24 are flush with the lower surface of the pre-manufactured circuit board 10.

In the present disclosure, the chip packaging unit 20 is embedded in the mounting recess 11 of the pre-manufactured circuit board, and the upper and lower surfaces of the chip packaging unit 20 are flush with the upper and lower surfaces of the pre-manufactured circuit board 10, respectively, to form a stable preliminary structure of the chip-embedded circuit board. Further, in the present disclosure, the electrode lead-out structure is formed on the upper surface of the pre-manufactured circuit board 10 for leading out the electrodes of the chip packaging unit 20, so as to be connected to other cooperative electronic elements to implement the operational performance of the chip-embedded circuit board. In the present disclosure, the slots are further provided in the back surface of the chip packaging unit 20 to form the heat dissipation fins 24 for increasing a heat dissipation area of the chip packaging unit 20, to implement effective heat dissipation of the chip packaging unit 20 and the pre-manufactured circuit board and thus improve the heat dissipation performance of the chip-embedded circuit board. In addition, the heat dissipation fins 24 are flush with the lower surface of the pre-manufactured circuit board 10, such that the overall structure of the chip-embedded circuit board is stable.

Thereby, with the method for manufacturing a chip-embedded circuit board in the present disclosure, the chip-embedded circuit board with the robust structure that meets the operational performance and the heat dissipation performance can be manufactured.

In some embodiments, stacking a dielectric layer 31 and a conductive layer 32 on the upper surface of the pre-manufactured circuit board 10 includes: stacking the dielectric layer 31 of a resin material on the upper surface of the pre-manufactured circuit board 10; and stacking and laminating the conductive layer 32 on an upper surface of the dielectric layer 31, such that the conductive layer 32 is fixedly connected to the pre-manufactured circuit board 10 by the dielectric layer 31.

The dielectric layer 31 of the resin material has a good adhesion. The dielectric layer 31 and the conductive layer 32 are sequentially stacked on the upper surface of the pre-manufactured circuit board 10 and are laminated, such that the conductive layer 32 is fixedly connected to the pre-manufactured circuit board 10 by the dielectric layer 31, and insulation and electrical isolation is implemented between the conductive layer 32 and the pre-manufactured circuit board 10.

FIG. 3 shows a structure of an electrode pattern formed in a conductive layer during manufacturing of a chip-embedded circuit board. FIG. 4 shows a structure of through holes formed in a conductive layer and a dielectric layer during manufacturing of a chip-embedded circuit board. As shown in FIG. 3 and FIG. 4, in some embodiments, providing the through holes in the dielectric layer 31 and the conductive layer 32 to expose electrodes of the chip packaging unit 20 includes: etching the conductive layer 32 to remove an unwanted portion, to remain the electrode pattern 320; and performing laser drilling on the electrode pattern 320 to form the through holes 310 that extend through the conductive layer 32 and the dielectric layer 31 and from which the electrodes of the chip packaging unit 20 are exposed. The electrodes of the chip packaging unit 20 may include a gate, a source, and a drain.

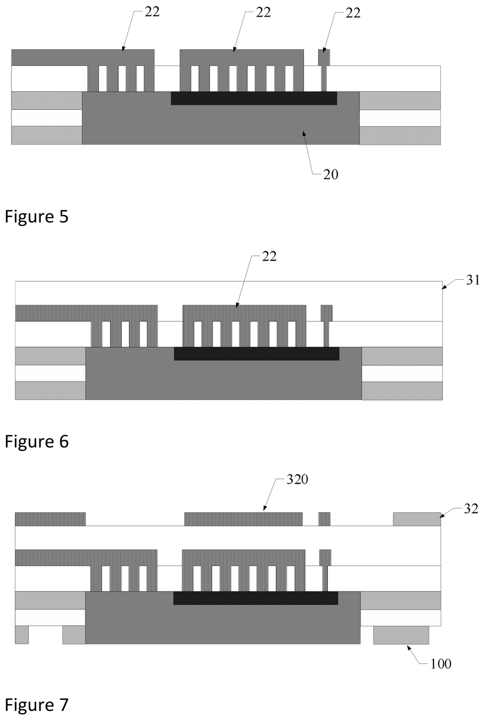

FIG. 5 shows a structure of electrode leads formed during manufacturing of a chip-embedded circuit board. As shown in FIG. 4 and FIG. 5, filling the through holes 310 with a conductive material to form electrode leads 22 of the chip packaging unit 20 includes: filling the through holes 310 with a copper material by electroplating, to form the electrode leads 22 of the chip packaging unit 20.

In some embodiments, the step of forming an electrode lead-out structure on the upper surface of the pre-manufactured circuit board 10 is repeated a plurality of times. That is, a plurality of dielectric layers 31 and a plurality of conductive layers 32 may be alternately stacked on the upper surface of the pre-manufactured circuit board 10, to form a multi-layer electrode lead-out structure.

Specifically, FIG. 6 shows a structure of a second dielectric layer formed during manufacturing of a chip-embedded circuit board. Referring to FIG. 6, a dielectric layer 31 is stacked for a second time such that the dielectric layer 31 stacked for the second time covers the electrode leads 22 formed for a first time and an area not covered by the electrode lead 22 formed for the first time, and an upper surface of the dielectric layer 31 stacked for the second time is flat.

FIG. 7 shows a structure of a second electrode pattern formed during manufacturing of a chip-embedded circuit board. As shown in FIG. 6 and FIG. 7, the conductive layer 32 continues to be stacked and laminated on the dielectric layer 31 stacked for the second time. Then the conductive layer 32 stacked for the second time is etched to form the electrode pattern 320. A position of the electrode pattern 320 formed for the second time at least partially overlaps a position of the electrode pattern 320 formed for the first time shown in FIG. 3.

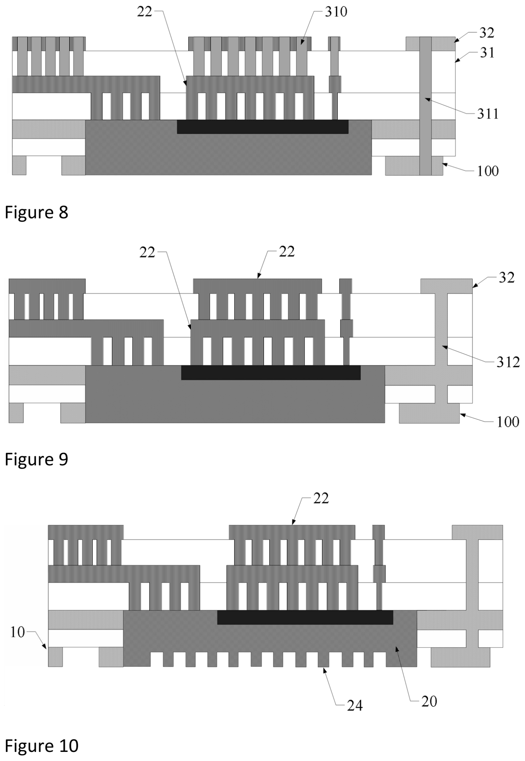

FIG. 8 shows a structure of a second layer of through holes formed during manufacturing of a chip-embedded circuit board. After the electrode pattern 320 is formed for the second time, as shown in FIG. 7 and FIG. 8, laser drilling is performed on the electrode pattern 320 formed for the second time, to form through holes 310 that extend through the conductive layer 32 and the dielectric layer 31 that are formed for the second time and that connects the electrode leads 22 formed for the first time.

FIG. 9 shows a structure of a second layer of electrode leads formed during manufacturing of a chip-embedded circuit board. As shown in FIG. 8 and FIG. 9, the through holes 310 formed for the second time continues to be filled with a copper material by electroplating, to form electrode leads 22. The electrode leads 22 formed for the second time are connected to the electrode leads 22 formed for the first time.

Depending on a design requirement, a dielectric layer and a conductive layer may further be stacked on the electrode leads formed for the second time and a corresponding electrode lead-out structure is formed.

In some embodiments, during formation of the electrode pattern 320 in the conductive layer 32, for example, during manufacturing of the chip-embedded circuit board shown in FIG. 7, a conductive pattern 100 is further etched in the lower surface of the pre-manufactured circuit board 10. The conductive pattern 100 is used for the lower surface of the chip-embedded circuit board to implement a required electrical connection. Further, during formation of the through holes 310 in the conductive layer 32 and the dielectric layer 31, for example, during manufacturing of the chip-embedded circuit board shown in FIG. 8, a channel 311 for communication between the conductive layer 32 and the conductive pattern 100 may further be formed by laser drilling. During formation of the electrode leads 22, for example, during manufacturing of the chip-embedded circuit board shown in FIG. 9, the channel 311 is further filled with a conductive material to form a conductive channel 312 connecting the conductive layer 32 and the conductive pattern 100.

FIG. 10 shows a structure of heat dissipation fins formed during manufacturing of a chip-embedded circuit board. As shown in FIG. 10, the method for manufacturing a chip-embedded circuit board further includes: providing slots in a back surface of the chip packaging unit 20 to form heat dissipation fins 24 in such a way that the heat dissipation fins 24 are flush with the lower surface of the pre-manufactured circuit board 10.

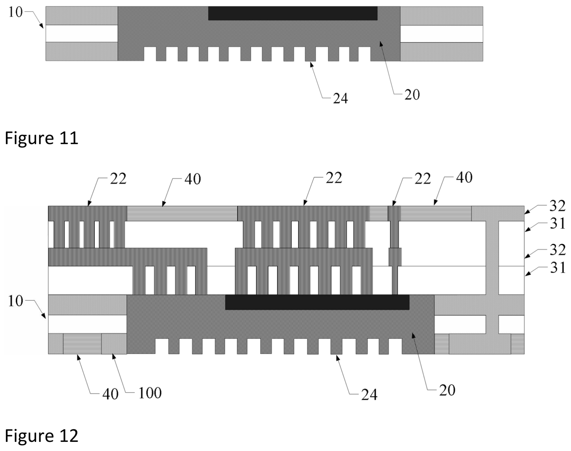

In this embodiment of the present disclosure, as shown in FIG. 10, the heat dissipation fins 24 may be manufactured after the electrode leads 22 are formed. Alternatively, as shown in FIG. 11, before the chip packaging unit 20 is embedded in the pre-manufactured circuit board 10, the heat dissipation fins 24 may be pre-manufactured on the back surface of the chip packaging unit 20, then the chip packaging unit 20 is embedded in the pre-manufactured circuit board 10, and the steps of forming an electrode lead-out structure above the pre-manufactured circuit board 10, forming a conductive pattern below the pre-manufactured circuit board 10, etc. are performed.

FIG. 12 shows a structure of an insulating protective layer formed during manufacturing of a chip-embedded circuit board. As shown in FIG. 2 and FIG. 12, in some embodiments, the method for manufacturing a chip-embedded circuit board further includes: forming an insulating protective layer 40 in areas that are above the pre-manufactured circuit board 10 and that are not covered by the electrode leads 22, and/or in areas that are below the pre-manufactured circuit board 10 and that are not covered by the conductive pattern 100. The insulating protective layer 40 is configured to protect the chip-embedded circuit board to implement performances such as insulation, oxidation resistance, and corrosion resistance.

An embodiment of the present disclosure further provides a chip-embedded circuit board manufactured by the method for manufacturing a chip-embedded circuit board according to any one of the above embodiments. The features and principles of the method for manufacturing a chip-embedded circuit board described according to any one of the above embodiments can be applied to the following embodiment of the chip-embedded circuit board. In the following embodiment of the chip-embedded circuit board, the features and principles of the chip-embedded circuit board that have been elucidated above are not repeated.

As shown in FIG. 2 and FIG. 12, the chip-embedded circuit board according to this embodiment of the present disclosure includes:
a pre-manufactured circuit board 10;
a chip packaging unit 20 embedded in a mounting recess 11 of the pre-manufactured circuit board 10, where upper and lower surfaces of the chip packaging unit 20 are flush with lower surfaces of the pre-manufactured circuit board 10, respectively; and
an electrode lead-out structure formed on the upper surface of the pre-manufactured circuit board 10 and including: a dielectric layer 31 and a conductive layer 32 that are stacked on the upper surface of the pre-manufactured circuit board 10, through holes extending through the dielectric layer 31 and the conductive layer 32 to connect electrodes of the chip packaging unit 20, and a conductive material filled in the through holes to form electrode leads 22 of the chip packaging unit 20; and
heat dissipation fins 24 provided on a back surface of the chip packaging unit 20, where the heat dissipation fins 24 are flush with the lower surface of the pre-manufactured circuit board 10.

Further, the chip-embedded circuit board further includes: an insulating protective layer 40 disposed above the pre-manufactured circuit board 10 and covering areas not covered by the electrode leads 22, where when a conductive pattern 100 is formed on the lower surface of the pre-manufactured circuit board 10, the insulating protective layer 40 is also disposed below the pre-manufactured circuit board 10, and covers areas not covered by the conductive pattern 100.

In the present disclosure, the chip packaging unit 20 is embedded in the mounting recess 11 of the pre-manufactured circuit board, and the upper and lower surfaces of the chip packaging unit 20 are flush with the upper and lower surfaces of the pre-manufactured circuit board 10, respectively, to form a stable preliminary structure of the chip-embedded circuit board. in the present disclosure, the electrode lead-out structure is formed on the upper surface of the pre-manufactured circuit board 10 for leading out the electrodes of the chip packaging unit 20, so as to be connected to other cooperative electronic elements to implement the operational performance of the chip-embedded circuit board. In the present disclosure, the slots are further provided on the back surface of the chip packaging unit 20 to form the heat dissipation fins 24 for increasing a heat dissipation area of the chip packaging unit 20, thereby implementing effective heat dissipation of the chip packaging unit 20 and the pre-manufactured circuit board, and improving heat dissipation performance of the chip-embedded circuit board. In addition, the heat dissipation fins 24 are flush with the lower surface of the pre-manufactured circuit board 10, so that the overall structure of the chip-embedded circuit board is stable. In addition, in the present disclosure, the insulating protective layer 40 is configured to implement insulation, oxidation prevention, and corrosion prevention for the chip-embedded circuit board.

The above is a further detailed description of the present disclosure with reference to the specific preferred implementations, and it cannot be considered that the specific implementation of the present disclosure is limited to these descriptions. For those of ordinary skill in the art of the present disclosure, several simple deductions or substitutions can be further made without departing from the concept of the present disclosure, and should be regarded as falling within the scope of protection of the present disclosure.

## Claims

1. A method for manufacturing a chip-embedded circuit board, comprising:
providing a mounting recess in a pre-manufactured circuit board;
embedding a chip packaging unit in the mounting recess such that upper and lower surfaces of the chip packaging unit are flush with upper and lower surfaces of the pre-manufactured circuit board, respectively; and
forming an electrode lead-out structure on the upper surface of the pre-manufactured circuit board by: stacking a dielectric layer and a conductive layer on the upper surface of the pre-manufactured circuit board, providing through holes in the dielectric layer and the conductive layer to expose electrodes of the chip packaging unit, and filling the through holes with a conductive material to form electrode leads of the chip packaging unit; and
providing slots in a back surface of the chip packaging unit to form heat dissipation fins in such a way that the heat dissipation fins are flush with the lower surface of the pre-manufactured circuit board.

2. The manufacturing method according to claim 1, wherein stacking a dielectric layer and a conductive layer on the upper surface of the pre-manufactured circuit board comprises:
stacking the dielectric layer of a resin material on the upper surface of the pre-manufactured circuit board; and
stacking and laminating the conductive layer on an upper surface of the dielectric layer, such that the conductive layer is fixedly connected to the pre-manufactured circuit board by the dielectric layer.

3. The manufacturing method according to claim 1, wherein providing through holes in the dielectric layer and the conductive layer to expose electrodes of the chip packaging unit comprises:
etching the conductive layer to form an electrode pattern; and
performing laser drilling on the electrode pattern to form the through holes that extend through the conductive layer and the dielectric layer and from which the electrodes of the chip packaging unit are exposed.

4. The manufacturing method according to claim 1, wherein filling the through holes with a conductive material to form electrode leads of the chip packaging unit comprises:
filling the through holes with a copper material by electroplating, to form the electrode leads.

5. The manufacturing method according to any one of claims 1 to 4, wherein the step of forming an electrode lead-out structure on the upper surface of the pre-manufactured circuit board is repeated a plurality of times.

6. The manufacturing method according to claim 5, wherein a dielectric layer is stacked for a second time such that the dielectric layer stacked for the second time covers the electrode leads formed for a first time and areas not covered by the electrode leads formed for the first time, and an upper surface of the dielectric layer stacked for the second time is flat; and
electrode leads are formed for the second time such that the electrode leads formed for the second time are connected to the electrode leads formed for the first time.

7. The manufacturing method according to claim 1, wherein during forming the electrode lead-out structure on the upper surface of the pre-manufactured circuit board,
the lower surface of the pre-manufactured circuit board is further etched to form a conductive pattern.

8. The manufacturing method according to claim 7, further comprising:
forming an insulating protective layer in areas that are above the pre-manufactured circuit board and that are not covered by the electrode leads, and/or in areas that are below the pre-manufactured circuit board and that are not covered by the conductive pattern.

9. A chip-embedded circuit board manufactured by using the manufacturing method according to any one of claims 1 to 8, the chip-embedded circuit board comprising:
a pre-manufactured circuit board;
a chip packaging unit embedded in a mounting recess in the pre-manufactured circuit board, wherein upper and lower surfaces of the chip packaging unit are flush with upper and lower surfaces of the pre-manufactured circuit board, respectively; and
an electrode lead-out structure formed on the upper surface of the pre-manufactured circuit board and comprising: a dielectric layer and a conductive layer that are stacked on the upper surface of the pre-manufactured circuit board, through holes extending through the dielectric layer and the conductive layer to connect electrodes of the chip packaging unit, and a conductive material filled in the through holes to form electrode leads of the chip packaging unit; and
heat dissipation fins provided on a back surface of the chip packaging unit, wherein the heat dissipation fins are flush with the lower surface of the pre-manufactured circuit board.

10. The chip-embedded circuit board according to claim 9, further comprising:
an insulating protective layer disposed above the pre-manufactured circuit board and covering areas not covered by the electrode leads,
wherein when a conductive pattern is formed on the lower surface of the pre-manufactured circuit board, the insulating protective layer is also disposed below the pre-manufactured circuit board, and covers areas not covered by the conductive pattern.
